# EUROPEAN PATENT SPECIFICATION

(11) **EP 2 017 360 B1**
(45) Date of publication and mention of the grant of the patent: **08.08.2012**
(21) Application number: 08165172.1
(22) Date of filing: 25.10.2004
(51) Int. Cl.: C22B 34/14, C22C 27/00, C23C 14/34

(54) **High purity hafnium, high purity hafnium target and method of manufacturing a thin film using high purity hafnium**
Hochreines Hafnium, hochreines Hafniumtarget und Verfahren zum Herstellen eines dünnen Filmes unter Verwendung hochreinen Hafniums
Hafnium de grande pureté, cible comprenant celui-ci, et procédé de production d'un film mince en hafnium de grande pureté

(30) Priority: 19.11.2003 JP 2003388737
(43) Date of publication of application: 21.01.2009
(62) Divisional of application: 04792914.6
(73) Proprietor: JX Nippon Mining & Metals Corporation, Tokyo 100-8164 (JP)
(72) Inventor: SHINDO, Yuichiro c/o Isohara Factory Nikko Mat. Co., Ltd,, Hanakawa-cho Ibaraki 319-1535 (JP)
(74) Representative: Hoarton, Lloyd Douglas Charles

(56) References cited:
- US-A- 4 722 827
- US-A- 4 923 531
- US-A1- 2002 194 953
- US-A1- 2003 062 261
- DATABASE COMPENDEX [Online] ENGINEERING INFORMATION, INC., NEW YORK, NY, US; 1980, FOLEY ERNEST: "PRODUCTION OF REACTOR GRADE ZrO2 AND HfO2" XP002423547 Database accession no. EIX82020002837 & 1980 METALL SOC OF AIME, WARRENDALE, PA, USA, 1980, pages 341-358,
- DATABASE COMPENDEX [Online] ENGINEERING INFORMATION, INC., NEW YORK, NY, US; 1966, GOODWIN J G ET AL: "Effects of oxygen on mechanical and corrosion properties of hafnium" XP002423556 Database accession no. EIX19670019735 & ASM -- TRANS; ASM -- TRANSACTIONS SEPT 1966 AMERICAN SOCIETY OF METALS (ASM), UNITED STATES, vol. 59, no. 3, September 1966 (1966-09), pages 384-397,

## Description

### TECHNICAL FIELD

The present invention relates to a high purity hafnium material in which the content of impurities such as zirconium, oxygen, sulfur and phosphorus contained in the hafnium is reduced, as well as to a target and thin film formed from such high purity hafnium material, and a manufacturing method of high purity hafnium.

### BACKGROUND ART

Conventionally, there are numerous documents relating to the manufacture of hafnium, and, since hafnium and zirconium are very similar in terms of atomic structure and chemical property, the inclusion of zirconium or the inclusion of zirconium in hafnium was never really acknowledged as a problem as exemplified below.

Hafnium and zirconium are superior in heat resistance and corrosion resistance, and are characterized in that they have a strong affinity with oxygen and nitrogen. And, since the oxides or nitrides thereof have superior stability in high temperatures, they are utilized as fire-resistant materials in the manufacture of nuclear ceramics, steel or castings. Further, recently, these are also being used as electronic materials or optical materials.

The manufacturing method of metal hafnium or metal zirconium is proposed as the same manufacturing method. As such example, there is a method of reacting a fluorine-containing zirconium or hafnium compound with metal aluminum or magnesium in inert gas, reducing gas or vacuum at a temperature of 400°C or higher (e.g., refer to Patent Document 1); a manufacturing method of reducing zirconium chloride, hafnium chloride or titanium chloride and manufacturing the respective metals thereof characterized in the sealing metal (e.g., refer to Patent Document 2); a manufacturing method of hafnium or zirconium characterized in the reaction container structure upon reducing zirconium tetrachloride or hafnium tetrachloride with magnesium and the manufacturing technique thereof (e.g., refer to Patent Document 3); a method of manufacturing chloro-, bromo- or iodic zirconium, hafnium, tantalum, vanadium and niobium compound vapor by introducing these into a crucible (e.g., refer to Patent Document 4); a method of refining zirconium or hafnium chloride or an acid chloride aqueous solution with strongly basic anion exchange resin (e.g., refer to Patent Document 5); a method of collecting zirconium via solvent extraction (e.g., refer to Patent Document 6); and a crystal bar hafnium manufacturing device having characteristics in the feed portion (e.g., refer to Patent Document 7).
[Patent Document 1] Japanese Patent Laid-Open Publication No. S60-17027
[Patent Document 2] Japanese Patent Laid-Open Publication No. S61-279641
[Patent Document 3] Japanese Patent Laid-Open Publication No. S62-103328
[Patent Document 4] WO89/11449
[Patent Document 5] Japanese Patent Laid-Open Publication No. H10-204554
[Patent Document 6] Japanese Patent Laid-Open Publication No. S60-255621
[Patent Document 7] Japanese Patent Laid-Open Publication No. S61-242993
US 2003/062261 discloses high purity hafrium for use in semiconductor applications

US 2003/062261 discloses high purity hafnium for use in semiconductor applications.

As described in the foregoing documents, although there are numerous refining methods and extraction methods of zirconium and hafnium, the inclusion of zirconium or the inclusion of zirconium in hafnium was never really acknowledged as a problem.

Nevertheless, in recent years, deposition on electronic components using hafnium silicide is being demanded. In such a case, even zirconium is an impurity, and there is a possibility that the required characteristics of the hafnium raw material may become unstable. Therefore, there is demand for a high purity hafnium material with reduced zirconium, and a target and thin film formed from such a material.

However, since there was no notion of separating hafnium and zirconium as described above, the actual condition is that there is no efficient and stable manufacturing technology for obtaining the foregoing high purity hafnium material with reduced zirconium, and a target and thin film formed from such a material. Further, since it is difficult to efficiently eliminate the impurities of oxygen, sulfur and phosphorus, this is another reason that high purification has been neglected heretofore.

Embodiments of the present invention is to provide a high purity hafnium material which uses a hafnium sponge with reduced zirconium as the raw material, and in which the content of oxygen, sulfur and phosphorus contained in the hafnium is reduced, as well as to a target and thin film formed from such material, and to the manufacturing method of high purity hafnium. Thereby provided is efficient and stable manufacturing technology which enables the manufacture of a high purity hafnium material, and a target and thin film formed from such material.

As a result of intense study, the present inventors discovered that the intended high purity hafnium can be manufactured by using a hafnium sponge with reduced zirconium developed previously by the inventors as the raw material, and further performing electron beam melting and deoxidation with molten salt so as to efficiently separate oxygen, sulfur and phosphorus, and, as necessary, further performing electron beam melting.

Based on the foregoing discovery, the present invention seeks to provide high purity hafnium, a target formed from high purity hafnium and a method of manufacturing a thin film using a target formed from high purity hafnium.

According to one aspect of the present invention, there is provided high purity hafnium as defined in claim 1 hereinafter.

According to another aspect of the present invention, there is provided a target formed from high purity hafnium as defined in claim 2 hereinafter.

According to a further aspect of the present invention, there is provided a method of manufacturing a thin film using a target formed from high purity hafnium as defined in claim 3 hereinafter.

Embodiments of the present invention yield a superior effect in that it is capable of stably manufacturing high purity hafnium by using a hafnium sponge in which the zirconium in the hafnium is eliminated as the raw material, and further performing electron beam melting and deoxidation with molten salt to this hafnium sponge. Further, by manufacturing a sputtering target with the high purity hafnium ingot obtained as described above and performing sputtering with this target, it is possible to obtain a high purity hafnium thin film.

In embodiments of the present invention, a hafnium sponge from which zirconium has been eliminated is used as the raw material. Upon eliminating zirconium from hafnium, a method invented previously by the present inventors may be adopted, or another raw material may be used so as long as it is hafnium with reduced zirconium.

The previous invention as a method for reducing zirconium is introduced below.

Hafnium tetrachloride (HfCl₄) is used as the raw material. A commercially available material can be used as the hafnium tetrachloride. This commercially available hafnium tetrachloride contains roughly 5wt% of zirconium. Incidentally, hafnium (Hf) metal or hafnium oxide (HfO₂) may also be used as the raw material.

These raw materials have a purity level of 3N excluding zirconium, and contain iron, chrome and nickel as main impurities other than zirconium.

First, this hafnium tetrachloride raw material is dissolved in purified water. Next, this is subject to multistage organic solvent extraction. Normally, solvent extraction is performed in 1 to 10 stages. TBP may be used as the organic solvent.

As a result, zirconium can be made to be 5000wtppm or less, and can be further made to be 1000wtppm or less by repeating solvent extraction. Further, the total content of other impurities can be made to be 1000wtppm or less.

Next, neutralization treatment is performed to obtain hafnium oxide (HfO₂). This hafnium oxide is subject to chlorination to obtain high purity hafnium tetrachloride (HfCl₄), and this is further reduced with, for instance, magnesium metal having chloridization power that is stronger than hafnium or zirconium to obtain a hafnium sponge. As the reducing metal, in addition to magnesium, for instance, calcium, sodium, and so on may be used.

In the present invention, the hafnium sponge obtained as described above is once subject to electron beam melting (hearth melting) in a Cu crucible. Thereafter, the hafnium sponge is sequentially placed therein. The hafnium molten metal overflowing from the upper part of the pool flows into the upper part of the ingot. This is still in a molten metal state, and the purity can be improved by performing the two melting processes with a series of electronic beam operations at the stages of hearth melting and manufacturing the ingot.

Thereafter, the obtained ingot is subject to deoxidation with molten salt. This deoxidation process, as described later, is able to eliminate carbon, sulfur, phosphorus and other impurities. Specifically, it is possible to make oxygen 40wtppm or less, and sulfur and phosphorus respectively 10wtppm or less. In the foregoing process, zirconium can be made to be 5000wtppm or less, and further 1000wtppm.

Like this, it is possible to obtain a high purity hafnium ingot having a purity of 4N (99.99wt%) or higher excluding gas components such as carbon, oxygen and nitrogen, and zirconium.

Further, it is possible to use this high purity hafnium to manufacture a high purity hafnium target, and it is further possible to deposit high purity hafnium on a substrate by performing sputtering with this high purity target.

Moreover, a material having a high residual resistance ratio can be obtained from the foregoing high purity hafnium material as described in the following Examples, and it is possible to sufficiently meet the demands as an electronic component material.

The target may be manufactured with the ordinary processing steps of forging, rolling, cutting, finishing (polishing) and so on. There is no particular limitation in the manufacturing method thereof, and the method may be selected arbitrarily.

### [Examples]

Examples of the present invention are now explained. These Examples are merely illustrative, and the present invention shall in no way be limited thereby. In other words, the present invention shall only be limited by the scope of the present invention, and shall include the various modifications other than the Examples of this invention.

### (Example 1)

100Kg of commercially available hafnium tetrachloride (HfCl₄) shown in Table 1 having a purity of 3N and containing roughly 5000wtppm of zirconium was used as the raw material, and this was dissolved in 1 L of purified water to create a nitric acid solution.

This raw material contained 500wtppm, 40wtppm and 1000wtppm of iron, chrome and nickel, respectively, as its main impurities in HfCl₄.

Next, this hafnium raw material (a nitric acid solution) was subject to 4-stage organic solvent extraction using a TBP organic solvent, and neutralization treatment was performed to obtain hafnium oxide (HfO₂).

Further, this hafnium oxide was subject to chlorination to obtain high purity hafnium tetrachloride (HfCl₄), and then subject to magnesium reduction to obtain a hafnium sponge as the raw material. This hafnium sponge contained 300wtppm of zirconium, and the total content of other impurities was reduced to 300wtppm.

Next, the obtained hafnium sponge was used as the raw material, and further subject to two-stage melting via hearth melting and ingot melting with an electron beam to remove volatile elements, gas components and so on. As a result of the foregoing process, although the zirconium content did not change at 300wtppm, iron, chrome, nickel and other impurities were reduced to 70wtppm as shown in Table 1, and further resulted in O: 250wtppm, C: 50wtppm, N: <10wtppm, S: <10wtppm, P: <10wtppm.

Next, the hafnium thus obtained was subject to deoxidation at 1200°C for 5 hours with molten salt of Ca and CaCl₂. Reduction was realized where O: <10wtppm and C: <10wtppm, and other impurities were also reduced to 30wtppm.

Accordingly, it is possible to obtain a high purity hafnium ingot having a purity level of 4N (99.99wt%) excluding zirconium.

The sputtering target obtained from this ingot is also capable of maintaining high purity, and, by performing sputtering with this target, a uniform high purity hafnium thin film can be formed on a substrate.

**[Table 1]**

| wtppm | | | | | | | |
|---|---|---|---|---|---|---|---|
| | O | C | N | S | P | Zr | Others |
| Raw Material | - | - | - | 20 | 20 | 5000 | 800 |
| Ingot | 250 | 50 | <10 | <10 | <10 | 300 | 70 |
| Deoxidation | <10 | <10 | <10 | <10 | <10 | 300 | 30 |

### (Reference example)

100Kg of hafnium metal raw material (zirconium content of 2 wt%) shown in Table 2 was used and dissolved in nitric-hydrofluoric acid. This raw material contained 15000wtppm, 8000wtppm and 5000wtppm of iron, chrome and nickel, respectively, as its main impurities in the raw material.

Next, this hafnium raw material was subject to 10-stage organic solvent extraction using a TBP organic solvent, and neutralization treatment was performed to obtain hafnium oxide (HfO₂).

Further, this hafnium oxide was subject to chlorination to obtain high purity hafnium tetrachloride (HfCl₄), and then subject to calcium reduction to obtain a hafnium sponge. This hafnium sponge contained 1500wtppm of zirconium, and the total content of other impurities was reduced to 1000wtppm.

Next, the obtained hafnium sponge was used as the raw material, and further subject to two-stage melting via hearth melting and ingot melting with an electron beam to remove volatile elements, gas components and so on. As a result of the foregoing process, as shown in Table 2, realized was O: 400wtppm, C: 30wtppm, N: <10wtppm, S: 10wtppm, P: 10wtppm.

Next, the hafnium thus obtained was subject to deoxidation at 1200°C for 10 hours with molten salt of Mg and MgCl₂. Reduction was realized where O: 20wtppm and C: 10wtppm, and other impurities were also reduced to 50wtppm.

With the sputtering target obtained from this ingot, as with Example 1, a uniform high purity hafnium thin film can be formed on a substrate.

**[Table 2]**

| wtppm | | | | | | | |
|---|---|---|---|---|---|---|---|
| | O | C | N | S | P | Zr | Others |
| Raw Material | 10000 | 5000 | 4000 | 100 | 50 | 20000 | 30000 |
| Ingot | 400 | 30 | <10 | 10 | 10 | 1500 | 100 |
| Deoxidation | 20 | 10 | <10 | <10 | <10 | 1500 | 50 |

### (Example 3)

100Kg of hafnium oxide (HfO₂) raw material (3N level) shown in Table 3 was used and dissolved in nitric-hydrofluoric acid. This raw material contained 15000wtppm, 8000wtppm and 5000wtppm of iron, chrome and nickel, respectively, as its main impurities in the raw material.

Next, this hafnium oxide raw material was chlorinated and subject to refining with distillation of 10 or more stages, then further subject to sodium reduction.

Next, the obtained hafnium was used as the raw material, and further subject to two-stage melting via hearth melting and ingot melting with an electron beam to remove volatile elements, gas components and so on. As a result of the foregoing process, as shown in Table 3, realized was Zr: 500wtppm, O: 100wtppm, C: 100wtppm, N: 20wtppm, S: 10wtppm, P: 10wtppm, others: 30wtppm.

Next, the hafnium thus obtained was subject to deoxidation at 1250°C, under argon pressure (4atm) for 10 hours with molten salt of Ca and CaCl₂. Reduction was realized where O, C, N, S, P<10wtppm, and other impurities were also reduced to 25wtppm.

With the sputtering target obtained from this ingot, as with Example 1, a uniform high purity hafnium thin film can be formed on a substrate.

**[Table 3]**

| wtppm | | | | | | | |
|---|---|---|---|---|---|---|---|
| | O | C | N | S | P | Zr | Others |
| Raw Material | - | 10000 | 5000 | 500 | 100 | 10000 | 10000 |
| Ingot | 100 | 100 | 20 | 10 | 10 | 500 | 30 |
| Deoxidation | <10 | <10 | <10 | <10 | <10 | 500 | 25 |

### [Industrial Applicability]

Since the present invention is able to stably manufacture high purity hafnium in which gas components such as oxygen and other impurity elements are reduced by using a hafnium sponge with reduced zirconium as the raw material and subjecting this hafnium sponge to electron beam melting and deoxidation processing with molten salt, such high purity hafnium can be used as a heat-resistant or corrosion-resistant material, or an electronic material or optical material.

## Claims

1. High purity hafnium having a purity of 4N or higher excluding zirconium and gas components, an oxygen content of 40wtppm or less, and in which the content of sulfur and phosphorus is respectively 10wtppm or less and the zirconium content is 0.1wt% or lower.

2. A target formed from high purity hafnium having a purity of 4N or higher excluding zirconium and gas components, an oxygen content of 40wtppm or less, and in which the content of sulfur and phosphorus is respectively 10wtppm or less and the zirconium content is 0.1wt% or lower.

3. A method of manufacturing a thin film using a target formed from high purity hafnium having a purity of 4N or higher excluding zirconium and gas components, an oxygen content of 40wtppm or less, and in which the content of sulfur and phosphorus is respectively 10wtppm or less and the zirconium content is 0.1wt% or lower.

## Patentansprüche

1. Hochreines Hafnium, das eine Reinheit von 4N oder höher ausschließlich Zirkonium und Gaskomponenten, einen Sauerstoffgehalt von 40 Gew. ppm oder weniger aufweist und in dem der Schwefel- und Phosphorgehalt jeweils 10 Gew. ppm oder weniger und der Zirkoniumgehalt 0,1 Gew.-% oder weniger beträgt.

2. Target, das aus hochreinem Hafnium gebildet ist, das eine Reinheit von 4N oder höher ausschließlich Zirkonium und Gaskomponenten, einen Sauerstoffgehalt von 40 Gew. ppm oder weniger aufweist und in dem der Schwefel- und Phosphorgehalt jeweils 10 Gew. ppm oder weniger und der Zirkoniumgehalt 0,1 Gew.-% oder weniger beträgt.

3. Verfahren zur Herstellung eines dünnen Films unter Verwendung eines Targets, das aus hochreinem Hafnium gebildet ist, das eine Reinheit von 4N oder höher ausschließlich Zirkonium und Gaskomponenten, einen Sauerstoffgehalt von 40 Gew. ppm oder weniger aufweist und in dem der Schwefel- und Phosphorgehalt jeweils 10 Gew. ppm oder weniger und der Zirkoniumgehalt 0,1 Gew.-% oder weniger beträgt.

## Revendications

1. Hafnium de grande pureté ayant une pureté de 4N ou plus, à l'exclusion des composants en zirconium et gaz, une teneur en oxygène de 40 ppm en poids ou moins, et dans lequel la teneur en soufre et en phosphore est respectivement de 10 ppm en poids ou moins et la teneur en zirconium est de 0,1 % en poids ou moins.

2. Une cible formée à partir de hafnium de grande pureté ayant une pureté de 4N ou plus, à l'exclusion des composants en zirconium et gaz, une teneur en oxygène de 40 ppm en poids ou moins, et dans laquelle la teneur en soufre et en phosphore est respectivement de 10 ppm en poids ou moins et la teneur en zirconium est de 0,1 % en poids ou moins.

3. Un procédé de fabrication d'un film mince à l'aide d'une cible formée à partir de hafnium de grande pureté ayant une pureté de 4N ou plus, à l'exclusion des composants en zirconium et gaz, une teneur en oxygène de 40 ppm en poids ou moins, et dans laquelle la teneur en soufre et en phosphore est respectivement de 10 ppm en poids ou moins et la teneur en zirconium est de 0,1 % en poids ou moins.
